# EUROPÄISCHE PATENTSCHRIFT

(11) **EP 1 764 873 B1**
(45) Veröffentlichungstag und Bekanntmachung des Hinweises auf die Patenterteilung: **08.07.2009**
(21) Anmeldenummer: 05020253.0
(22) Anmeldetag: 16.09.2005
(51) Int. Cl.: H01R 9/26

(54) **Modulares Steuerungsgerät mit Terminal- und Funktionsmodulen**
Modular control equipment with terminal and function modules
Contrôleur modulaire avec modules terminales et fonctionnels

(43) Veröffentlichungstag der Anmeldung: 21.03.2007
(73) Patentinhaber: SIEMENS AKTIENGESELLSCHAFT, 80333 München (DE)
(72) Erfinder: Bräunlich, Michael, 09117 Chemnitz (DE); Meier, Frank-Günter, 09212 Limbach-Oberfrohna (DE)

(56) Entgegenhaltungen:
- DE-A1- 19 807 710
- US-A- 4 171 861
- US-A1- 2001 039 149

## Beschreibung

Die Erfindung betrifft ein Terminalmodul mit Anschlussklemmen, auf das ein Funktionsmodul aufsteckbar ist, zum modularen Aufbau eines Steuerungssystems, wobei das Terminalmodul beidseitig Kontakte aufweist, die sowohl intern elektrisch miteinander verbunden sind als auch elektrische Verbindungen zur Schnittstelle für die Funktionsmodule aufweisen. Die Erfindung betrifft ferner einen Funktionsbaustein gemäß dem Oberbegriff des Anspruchs 3 sowie ein modular aufgebautes Steuerungssystem, das mindestens zwei derartige Terminalmodule und mindestens einen derartigen Funktionsbaustein aufweist.

Ein derartiges System, z.B. die Baugruppe im Dokument DE-A-19807710, kommt insbesondere auf dem Gebiet der industriellen Automation zum Einsatz. Modular gestaltete industrielle Steuerungen sind oft in Terminalmodule und dazu passende Funktionsmodule (digitale oder analoge Ein- bzw. Ausgaben, Zähler und andere Spezialmodule) untergliedert. So lässt sich nach dem Aneinanderreihen der klemmentragenden Terminalmodule bereits die Verdrahtung realisieren. Die Terminalmodule sind sowohl für den Anschluss der Peripheriesignale als auch für die Weiterleitung der internen Steuerungssignale zuständig. Funktionsbedingt sind bei den Terminalmodulen einige spezielle Typen erforderlich und denkbar:
- Einspeisemodule, die die Einspeisung einer
   Versorgungsspannung für digitale E/A-Funktionen ermöglichen (Eröffnung einer Potentialgruppe für digitale Funktionsmodule, die aus einem Netzgerät gespeist werden sollen),
- Weiterleitungsmodule, die die Versorgungsspannung zum nächsten Terminalmodul weiterleiten und dem Funktionsmodul zur Verfügung stellen (wenn das nachfolgende digitale E/A-Modul vom selben Netzgerät gespeist werden soll),
- Durchschleifmodule, die die Versorgungsspannung zum nächsten Terminalmodul weiterleiten, aber dem Funktionsmodul nicht zur Verfügung stellen (wenn ein oder mehrere analoge Funktionsmodule an der Stelle benötigt werden, die Potentialgruppe aber nicht aufgehoben, also anschließend kein neues Einspeisemodul verwendet werden soll),
- Trennmodule, die die Versorgungsspannung nicht weiterleiten (hier können analoge Funktionsmodule oder Spezialmodule gesteckt werden) und
- Spezialmodule, die z.B. einen Temperatursensor für die Messung der Klemmen-Referenz-Temperatur enthalten.
   Mit dem Stecken der Funktionsmodule wird die Steuerung entsprechend dem geplanten Funktionsumfang komplettiert. Mit solch einem modularen Aufbau lassen sich vor allem im dezentralen Anwendungsfall der Ausbaugrad der Steuerung relativ genau an die vor Ort erforderlichen Steuerungsaufgaben anpassen.

Da wegen des gesamten Funktionsumfanges einer solchen modularen Steuerung oft mehrfach oben benannte spezielle Terminalmodule verwendet werden müssen, ist bei der Projektierung und Bestellung sowie beim Aufbau ein entsprechender Aufwand erforderlich. Ein großer Nachteil entsteht aber vor allem bei einer nachträglichen Erweiterung der Steuerungsfunktionen. Kommen beispielsweise in einer Potentialgruppe Funktionen hinzu, muss oft durch eine Neuanordnung der Terminalmodule ein großer Teil des Aufbaus unter Lösung der Verdrahtung geändert werden.

Aus dem Steuerungssystem ET 200S von Siemens sind entsprechend gestaltete - wie oben beschrieben -Terminalmodule bekannt, die dieses Problem nicht lösen. Andere ähnliche Anwendungen wie beispielsweise MELSEC ST von Mitsubishi Electric lösen das Problem ebenfalls nicht.

Der Erfindung liegt die Aufgabe zugrunde, ein modular aufgebautes Steuerungssystem mit Terminalmodulen und Funktionsbausteinen der eingangs genannten Art zu schaffen, das den Aufwand bei der Projektierung und Bestellung sowie beim Aufbau im Vergleich zu den bekannten Systemen reduziert und eine Neuanordnung der Terminalmodule bei einer Systemerweiterung und eine damit gegebenenfalls verbundene Neuverdrahtung unnötig macht.

Diese Aufgabe wird bei einem Terminalmodul der eingangs genannten Art dadurch gelöst, dass das Terminalmodul Kontakte für einen Funktionsbaustein aufweist, wobei der Funktionsbaustein zur Bereitstellung einer erforderlichen Funktionalität des Terminalmoduls vorgesehen ist.

Diese Aufgabe wird ferner durch einen Funktionsbaustein zum Bereitstellen der Funktionalität mindestens eines Terminalmoduls, wobei jedes Terminalmodul beidseitig Kontakte aufweist, die sowohl intern elektrisch miteinander verbunden sind als auch elektrische Verbindungen zu einer Schnittstelle für ein Funktionsmodul aufweisen, das auf das Terminalmodul aufsteckbar ist, wobei der Funktionsbaustein zur Verbindung von mindestens zwei in einer Kette geschalteten Terminalmodulen durch Aufstecken auf die entsprechenden Kontakte vorgesehen ist, gelöst.

Diese Aufgabe wird schließlich durch ein modular aufgebautes Steuerungssystem mit den in Anspruch 14 angegebenen Merkmalen gelöst.

Durch die erfindungsgemäße Verwendung von baugleichen Terminalmodulen, deren unterschiedliche Funktionalität durch mindestens einen zusätzlichen steckbaren Funktionsbaustein realisiert wird, zum Aufbau eines modularen Steuerungssystems ergibt sich eine einfachere und fehlerfreie Vormontage der einheitlichen Terminalmodule und eine bedeutend problemlosere Änderung der Konfiguration des Systems. Des weiteren wird die Ersatzteilhaltung des Anwenders vor allem im Hinblick auf geplante Anpassungen und Erweiterungen wesentlich vereinfacht.

In einer vorteilhaften Ausführungsform sind die Anschlussklemmen an den vereinheitlichten Terminalmodulen auf einen für die eigentliche Aufgabe ausreichenden Maximalquerschnitt von 1,5 mm^2 reduziert, da der Anschluss einer Versorgungsspannung und ein, falls erforderlich, PE-Anschluss an einem als Einspeisebaustein ausgeführten Funktionsbaustein anbringbar ist und für den PE-Anschluss ein Mindestquerschnitt von 2,5 mm^2 bei einer Einspeisung für eine Verteilung erforderlich ist.

In einer ebenfalls vorteilhaften Form der Ausführung weisen die Funktionsbausteine Mittel zur Visualisierung der bereitgestellten Funktionalität auf. Damit ist eine leichte optische Kontrolle des Aufbaus möglich und es ergibt sich eine gute Übersichtlichkeit des gesamten Steuerungssystems hinsichtlich Einspeisung von Versorgungsspannungen, Potentialweiterleitung und -trennung und Spezialfunktionen.

In einer besonders vorteilhaften Form der Ausführung sind durch die Funktionsbausteine jeweils zwei benachbarte Terminalmodule verbindbar, und für die Funktionsbausteine ist eine maximale Breite von der Breite eines Terminalmoduls vorgesehen. Dadurch können die einzelnen Funktionsbausteine individuell in einer Kette zusammengestellt werden, wobei die Funktionsbausteine auf die Kontakte der jeweiligen Terminalmodule im Halbraster gesteckt werden. Haben die Funktionsbausteine genau die Breite eines Terminalmoduls, so werden benachbarte Terminalmodule so mit den Funktionsbausteinen verbunden, dass ein genaues Aneinanderreihen der Funktionsbausteine möglich ist. Außerdem ergibt sich durch die Verwendung von Funktionsbausteinen, durch die jeweils nur zwei benachbarte Terminalmodule verbunden werden, ein leichtes und übersichtliches Handling bei einer schrittweisen Inbetriebnahme, und es ist das Abschalten einzelner Potentialgruppen ohne Lösen von Drähten möglich.

In einer vorteilhaften Form der Ausführung ist ein Funktionsbaustein als ein Einspeisebaustein ausgeführt, der Klemmen für den Anschluss einer Versorgungsspannung aufweist, die über eine interne elektrische Verbindung nur an den rechten Kontakten anlegbar ist, wodurch das links gelegene Terminalmodul von einer am rechts gelegenen Terminalmodul beginnbaren Potentialgruppe abtrennbar ist. Damit kann dieser so genannte "Einspeisebaustein R" an Stellen eingesetzt werden, an denen nach einer vorhandenen eine neue Potentialgruppe eröffnet werden soll.

In einer weiteren vorteilhaften Form der Ausführung ist ein Funktionsbaustein als ein Einspeisebaustein ausgeführt, der Klemmen für den Anschluss einer Versorgungsspannung aufweist, die über eine interne elektrische Verbindung nur an den linken Kontakten anlegbar ist, wodurch das rechts gelegene Terminalmodul von einer am links gelegenen Terminalmodul beginnbaren Potentialgruppe abtrennbar ist. Damit kann auch dieser so genannte "Einspeisebaustein L" an Stellen eingesetzt werden, an denen nach einer vorhandenen eine neue Potentialgruppe eröffnet werden soll.

In einer weiteren vorteilhaften Form der Ausführung ist ein Funktionsbaustein als ein Einspeisebaustein ausgeführt, der Klemmen für den Anschluss einer Versorgungsspannung aufweist, die über eine interne elektrische Verbindung an den linken und rechten Kontakten anlegbar ist. Damit kann dieser so genannte "Einspeisebaustein A" an Stellen eingesetzt werden, an denen nach einer vorhandenen Trennung eine neue Potentialgruppe eröffnet werden soll bzw. direkt am Anfang.

In einer besonders vorteilhaften Form der Ausführung weisen diese als Einspeisebausteine ausgeführten Funktionsbausteine noch eine zusätzliche Klemme für einen PE-Anschluss auf.

In einer weiteren besonders vorteilhaften Form der Ausführung ist für den genannten PE-Anschluss ein Mindestquerschnitt von 2,5 mm^2 vorgesehen, wie es bei einer Einspeisung für eine Verteilung erforderlich ist.

In einer ebenfalls vorteilhaften Form der Ausführung ist ein Funktionsbaustein als ein Brückenbaustein ausgeführt, der eine interne elektrische Verbindung zwischen allen oder nur bestimmten der linken und rechten Kontakte aufweist. So lassen sich Potentialgruppen mit oder ohne PE schaffen.

In einer weiteren vorteilhaften Form der Ausführung ist ein Funktionsbaustein als ein Trennbaustein ausgeführt, der keine interne elektrische Verbindung zwischen den linken und rechten Kontakten aufweist. Eine Potentialgruppe wird hiermit beendet, und es können analoge oder Spezialmodule gesteckt werden.

In einer besonders vorteilhaften Form der Ausführung ist ein Funktionsbaustein als ein Spezialbaustein ausgeführt, der beispielsweise einen oder zwei Temperatursensoren enthalten kann.

In einer vorteilhaften Ausführungsform des Steuerungssystems weist dieses ein Interfacemodul mit einem Interfaceanschluss-Stecker am Anfang der Kette von mindestens zwei Terminalmodulen auf.

In einer ebenso vorteilhaften Ausführungsform des Steuerungssystems weist dieses ein Abschlussmodul am Ende der Kette von mindestens zwei Terminalmodulen auf.

In einer besonders vorteilhaften Ausführungsform des Steuerungssystems ist am Anfang und am Ende der Kette aus mindestens einem Funktionsbaustein, durch die die Kette aus mindestens zwei Terminalmodulen verbindbar ist, ein Abschlussbaustein zum Abdecken der freien Kontakte vorgesehen. Diese können baugleich sein.

Vorteilhafterweise weisen diese Abschlussbausteine eine Breite von im Wesentlichen der Hälfte der Breite eines Terminalmoduls auf.

Im Folgenden wird die Erfindung anhand der in den Figuren dargestellten Ausführungsbeispiele näher beschrieben und erläutert. Es zeigen:
- FIG 1: ein Ausführungsbeispiel des erfindungsgemäßen Steuerungssystems komplett mit Terminal- und Funktionsmodulen, Interface- und Abschlussmodul, Inter-faceanschluss-Stecker und Funktionsbausteinen,
- FIG 2: das erfindungsgemäße Steuerungssystem aus FIG 1 ohne Funktionsmodule,
- FIG 3: ein erfindungsgemäßes Terminalmodul,
- FIG 4: zwei der erfindungsgemäßen Terminalmodule, die mit einem Ausführungsbeispiel eines Funktionsbausteins verbunden sind,
- FIG 5: einen "Einspeisebaustein R" mit PE-Anschluss als Ausführungsbeispiel eines Einspeisebausteins,
- FIG 6: ein Schaltschema des "Einspeisebausteins R" aus FIG 5,
- FIG 7: einen "Einspeisebaustein L" mit PE-Anschluss als Ausführungsbeispiel eines Einspeisebausteins,
- FIG 8: ein Schaltschema des "Einspeisebausteins L" aus FIG 7,
- FIG 9: einen "Einspeisebaustein A" mit PE-Anschluss als Ausführungsbeispiel eines Einspeisebausteins,

- FIG 10: ein Schaltschema des "Einspeisebausteins A" aus FIG 9,
- FIG 11: einen als Brückenbaustein ausgeführten Funktionsbaustein mit Sicht von oben,
- FIG 12: den Brückenbaustein aus FIG 11 mit Sicht von unten,
- FIG 13: ein Schaltschema des Brückenbausteins aus FIG 11 und FIG 12,
- FIG 14: einen als Trennbaustein ausgeführten Funktionsbaustein mit Sicht von oben,
- FIG 15: den Trennbaustein aus FIG 14 mit Sicht von unten,
- FIG 16: ein Schaltschema des Trennbausteins aus FIG 14 und FIG 15.

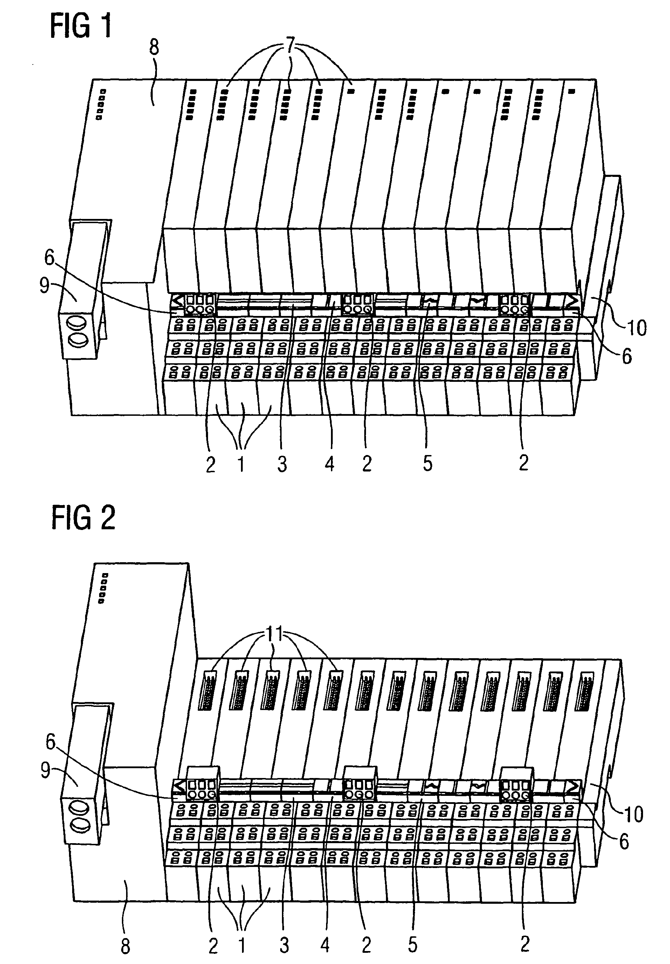

FIG 1 zeigt ein Ausführungsbeispiel des erfindungsgemäßen Steuerungssystems, bestehend aus einer Kette von Terminalmodulen 1 mit Anschlussklemmen 14, auf die Funktionsmodule 7 gesteckt sind. Am Anfang der Kette aus Terminalmodulen 1 befindet sich ein Interfacemodul 8 mit einem Interfaceanschluss-Stecker 9, das Ende der Kette bildet ein Abschlussmodul 10. In diesem Ausführungsbeispiel verbinden die Funktionsbausteine jeweils nur zwei benachbarte Terminalmodule 1, wobei die Breite der Funktionsbausteine genau der Breite eines Terminalmoduls 1 entspricht. Die Figur zeigt drei Einspeisebausteine 2 mit drei Anschlussklemmen für die Stromversorgung und einen PE-Anschluss. Danach erkennt man Brückenbausteine 3 und Trennbausteine 4, die auf Grund ihrer unterschiedlichen Markierung 15 gut zu unterscheiden sind. Außerdem erkennt man noch zwei Spezialbausteine 5; den Anfang und das Ende der Kette aus Funktionsbausteinen bildet je ein Abschlussbaustein 6.

FIG 2 zeigt das gleiche Ausführungsbeispiel wie in FIG 1 dargestellt, lediglich ohne die Funktionsmodule 7. Zu erkennen sind daher die Schnittstellen zu den Funktionsmodulen 11 mit den Kontakten, auf die die Funktionsmodule 7 aufgesteckt werden. Für die Beschreibung der weiteren Bezugszeichen in FIG 2 wird auf die Beschreibung zu FIG 1 verwiesen.

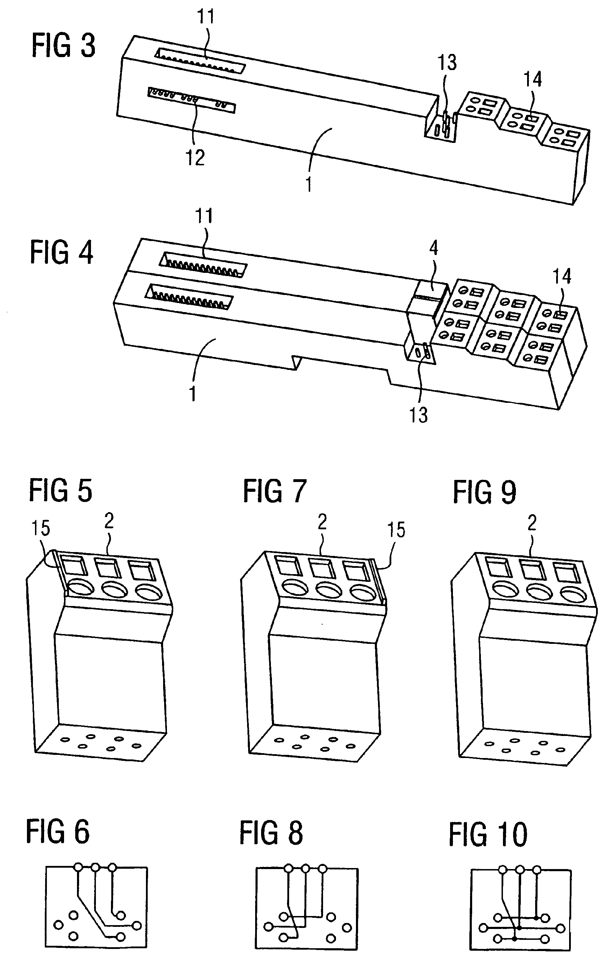

FIG 3 zeigt ein einzelnes Terminalmodul 1 mit einer Schnittstelle zum Funktionsmodul 11, den Kontakten für Steuerungssignale 12, den Kontakten für Funktionsbausteine 13 sowie die Anschlussklemmen 14.

FIG 4 zeigt zwei erfindungsgemäße Terminalmodule 1, die mit einem als Einspeisebaustein 2 ausgeführten Funktionsbaustein verbunden sind. Die Breite des Funktionsbausteins entspricht der Breite eines Terminalmoduls 1, so dass sich die im Halbraster auf die Terminalmodule 1 gesteckten Funktionsbausteine lückenlos aneinanderreihen. Die noch freien der Kontakte für die Funktionsbausteine 13 werden, wenn noch ein weiteres Terminalmodul 1 angeschlossen wird, von einem weiteren Funktionsbaustein belegt, oder, am Anfang oder Ende der Kette aus Terminalmodulen 1, mit einem Abschlussbaustein 6 belegt. Weiterhin sind wieder die Schnittstellen zu den Funktionsmodulen 11 und die Anschlussklemmen 14 der Terminalmodule 1 zu sehen.

FIG 5 zeigt als Ausführungsbeispiel eines Einspeisebausteins 2 einen "Einspeisebaustein R" mit PE-Anschluss, bei dem eine angeschlossene Versorgungsspannung über eine interne elektrische Verbindung nur an den rechten Kontakten anliegt. Links von den Anschlussklemmen für die Stromversorgung und dem PE-Anschluss ist eine Markierung 15 zu sehen, die den Einspeisebaustein 2 durch einen senkrechten Grat als Hinweis auf eine Trennung kennzeichnet.

FIG 6 zeigt ein Schaltschema des "Einspeisebausteins R" aus FIG 5, an dem zu sehen ist, wie die interne elektrische Verbindung geschaltet ist.

FIG 7 zeigt als Ausführungsbeispiel eines Einspeisebausteins 2 einen "Einspeisebaustein L" mit PE-Anschluss, bei dem eine angeschlossene Versorgungsspannung über eine interne elektrische Verbindung nur an den linken Kontakten anliegt. Rechts von den Anschlussklemmen für die Stromversorgung und dem PE-Anschluss ist eine Markierung 15 zu sehen, die den Einspeisebaustein 2 durch einen senkrechten Grat als Hinweis auf eine Trennung kennzeichnet.

FIG 8 zeigt ein Schaltschema des "Einspeisebausteins L" aus FIG 7, an dem zu sehen ist, wie die interne elektrische Verbindung geschaltet ist.

FIG 9 zeigt als Ausführungsbeispiel eines Einspeisebausteins 2 einen "Einspeisebaustein A" mit PE-Anschluss, bei dem eine angeschlossene Versorgungsspannung über eine interne elektrische Verbindung an den linken und rechten Kontakten anliegt.

FIG 10 zeigt ein Schaltschema des "Einspeisebausteins A" aus FIG 9, an dem zu sehen ist, wie die interne elektrische Verbindung geschaltet ist.

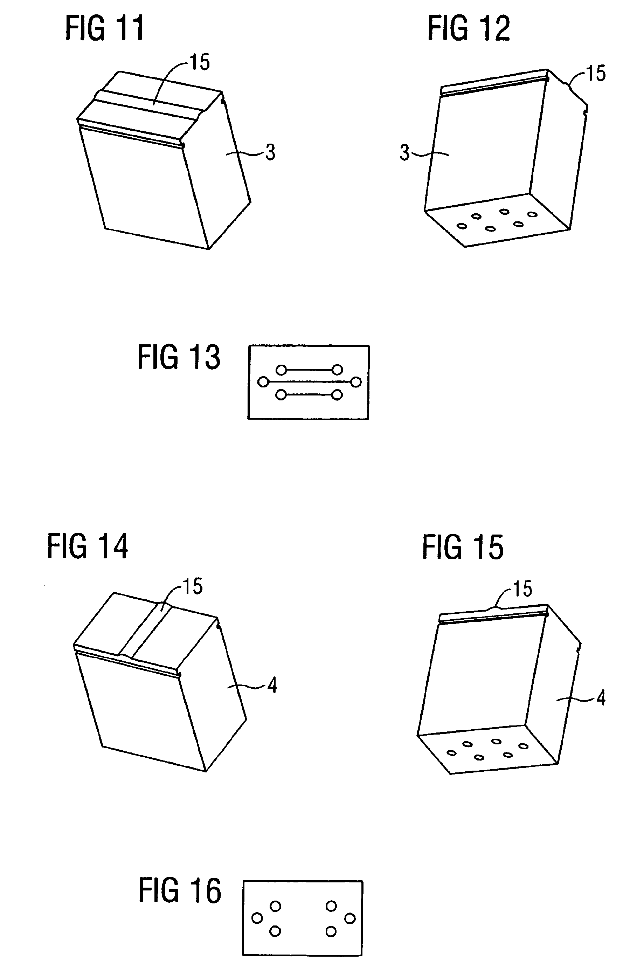

FIG 11 zeigt einen als Brückenbaustein 3 ausgeführten Funktionsbaustein, der eine interne elektrische Verbindung zwischen allen der linken und rechten Kontakte aufweist. Als Markierung 15 für den Funktionsbaustein zur Visualisierung einer durchgehenden elektrischen Verbindung dient bei einem Brückenbaustein 3 ein durchgehender waagerechter Grat, wie in dieser Darstellung mit Sicht von oben gut zu sehen ist.

FIG 12 zeigt den Brückenbaustein 3 aus FIG 11 von schräg unten mit Sicht auf die Kontakte, die bei der gezeigten Ausführungsform zwei Terminalmodule 1 miteinander verbinden.

FIG 13 zeigt ein Schaltschema des Brückenbausteins 3 aus FIG 11 und FIG 12, an dem zu sehen ist, wie die interne elektrische Verbindung geschaltet ist.

FIG 14 zeigt einen als Trennbaustein 4 ausgeführten Funktionsbaustein, der keine interne elektrische Verbindung zwischen den linken und rechten Kontakten aufweist. Als Markierung 15 für den Funktionsbaustein zur Visualisierung keiner durchgehenden elektrischen Verbindung dient bei einem Trennbaustein 4 - wie schon bei den Einspeisebausteinen 2 in den Figuren 5, 7 und 9 - ein senkrechter Grat.

FIG 15 zeigt den Trennbaustein 4 aus FIG 14 von schräg unten mit Sicht auf die Kontakte, die bei der gezeigten Ausführungsform zwei Terminalmodule 1 miteinander verbinden.

FIG 16 zeigt ein Schaltschema des Trennbausteins 4 aus FIG 14 und FIG 15, an dem zu sehen ist, wie die interne elektrische Verbindung geschaltet ist.

Zusammenfassend betrifft die Erfindung ein modulares Steuerungssystem, das aus Terminalmodulen und dazu passenden Funktionsmodulen aufgebaut ist, zum Einsatz insbesondere in der industriellen Automation. Bei den bekannten Ausführungsformen, die aus unterschiedlichen Terminalmodulen für verschiedene Funktionalitäten bestehen, lassen sich nachträgliche Systemerweiterungen oft nur unter großem Aufwand realisieren. Dieses Problem wird bei dem erfindungsgemäßen modularen Steuerungssystem durch die Verwendung neuartiger, baugleicher Terminalmodule gelöst, wobei die unterschiedlichen Funktionalitäten durch zusätzliche Funktionsbausteine bereitgestellt werden. Zusätzliche Vorteile sind neben der problemloseren Änderung der Konfiguration des Systems ein geringerer Aufwand für Projektierung und Aufbau, eine einfachere und fehlerfreie Vormontage der einheitlichen Terminalmodule, eine einfachere Ersatzteilhaltung, eine gute Übersichtlichkeit hinsichtlich der Einspeisung von Versorgungsspannungen, Potentialweiterleitung und -trennung und Spezialfunktionen sowie ein leichtes und übersichtliches Handling bei einer schrittweisen Inbetriebnahme.

## Patentansprüche

1. Terminalmodul (1), auf das ein Funktionsmodul (7) über eine Schnittstelle (11) aufsteckbar ist zum modularen Aufbau eines Steuerungssystems, wobei das Terminalmodul beidseitig Kontakte (12) für Steuerungssignale, die sowohl intern elektrisch miteinander verbunden sind als auch elektrische Verbindungen zu der Schnittstelle (11) für das Funktionsmodul aufweisen, sowie Anschlussklemmen (14), sowie Kontakte (13) für einen Funktionsbaustein (2,3,4,5,6) aufweist, und das Terminalmodul geeignet ist mit einem benachbarten Terminalmodul verbunden zu werden,
**dadurch gekennzeichnet,**
**dass** die Anschlussklemmen (14) und die Kontakte (13) für den Funktionsbaustein unterschiedlich ausgelegt sind, und unterschiedliche Funktionen haben, wobei der anzuschließende Funktionsbaustein zur Bereitstellung einer Funktionalität des Terminalmoduls vorgesehen ist.

2. Modular aufgebautes Steuerungssystem mit mindestens zwei Terminalmodulen (1) und zwei Funktionsmodulen (7), jeder Terminalmodul weist eine Schnittstelle (11) auf, über die ein entsprechendes Funktionsmodul aufsteckbar ist, jedes Terminalmodul weist beidseitig Kontakte (12) für Steuerungssignale auf, die sowohl intern elektrisch miteinander verbunden sind als auch elektrische Verbindungen zu der Schnittstelle für das Funktionsmodul aufweisen, und jedes Terminalmodul weist Kontakte (13) für einen Funktionsbaustein auf,
**dadurch gekennzeichnet,**
**dass** das Steuerungssystem mindestens einen Funktionsbaustein (2,3,4,5,6) aufweist, der zur Verbindung von benachbarten in einer Kette geschalteten Terminalmodulen durch Aufstecken auf die entsprechenden Kontakte (13) vorgesehen ist, wobei der anzuschließende Funktionsbaustein zur Bereitstellung einer Funktionalität der Terminalmodule vorgesehen ist.

3. Steuerungssystem nach Anspruch 2,
wobei ein Interfacemodul (8) mit einem Interfaceanschluss-Stecker am Anfang einer Kette von mindestens zwei Terminalmodulen (1) angeordnet ist.

4. Steuerungssystem nach Anspruch 3,
wobei ein Abschlussmodul (10) am Ende der Kette von mindestens zwei Terminalmodulen (1) angeordnet ist.

5. Steuerungssystem nach einem der Ansprüche 2 bis 4,
wobei der Funktionsbaustein (2,3,4,5,6) Mittel zur Visualisierung der bereitgestellten Funktionalität aufweist.

6. Steuerungssystem nach einem der Ansprüche 2 bis 5,
wobei für den Funktionsbaustein (2,3,4,5,6) eine maximale Breite von der Breite eines Terminalmoduls (1) vorgesehen ist.

7. Steuerungssystem nach einem der Ansprüche 2 bis 6,
wobei ein Funktionsbaustein (2,3,4,5,6) als ein Einspeisebaustein (2) ausgeführt ist, der Klemmen für den Anschluss einer Versorgungsspannung aufweist, die über eine interne elektrische Verbindung nur an den rechten Kontakten anlegbar ist, wodurch das links gelegene Terminalmodul (1) von einer am rechts gelegenen Terminalmodul (1) beginnbaren Potentialgruppe abtrennbar ist.

8. Steuerungssystem nach einem der Ansprüche 2 bis 7,
wobei ein Funktionsbaustein (2,3,4,5,6) als ein Einspeisebaustein (2) ausgeführt ist, der Klemmen für den Anschluss einer Versorgungsspannung aufweist, die über eine interne elektrische Verbindung nur an den linken Kontakten anlegbar ist, wodurch das rechts gelegene Terminalmodul (1) von einer am links gelegenen Terminalmodul (1) beginnbaren Potentialgruppe abtrennbar ist.

9. Steuerungssystem nach einem der Ansprüche 2 bis 8,
wobei ein Funktionsbaustein (2,3,4,5,6) als ein Einspeisebaustein (2) ausgeführt ist, der Klemmen für den Anschluss einer Versorgungsspannung aufweist, die über eine interne elektrische Verbindung an den linken und rechten Kontakten anlegbar ist.

10. Steuerungssystem nach einem der Ansprüche 2 bis 9,
wobei ein Funktionsbaustein (2,3,4,5,6) eine zusätzliche Klemme für einen PE-Anschluss aufweist.

11. Steuerungssystem nach Anspruch 10,
wobei für den PE-Anschluss ein Mindestquerschnitt von 2,5 mm^2 vorgesehen ist.

12. Steuerungssystem nach einem der Ansprüche 2 bis 11,
wobei ein Funktionsbaustein (2,3,4,5,6) als ein Brückenbaustein (3) ausgeführt ist, der eine interne elektrische Verbindung zwischen allen oder nur bestimmten der linken und rechten Kontakte aufweist.

13. Steuerungssystem nach einem der vorhergehenden Ansprüche,
wobei ein Funktionsbaustein (2,3,4,5,6) als ein Trennbaustein (4) ausgeführt ist, der keine interne elektrische Verbindung zwischen den linken und rechten Kontakten aufweist.

14. Steuerungssystem nach einem der vorhergehenden Ansprüche,
wobei ein Funktionsbaustein als ein Spezialbaustein (5) ausgeführt ist, der beispielsweise Temperatursensoren enthalten kann.

15. Steuerungssystem nach einem der Ansprüche 3 bis 14,
wobei am Anfang und am Ende der Kette ein Abschlussbaustein (6) zum Abdecken der freien Kontakte vorgesehen ist.

16. Steuerungssystem nach Anspruch 15,
wobei der Abschlussbaustein (6) eine Breite von im Wesentlichen der Hälfte der Breite eines Terminalmoduls (1) aufweist.

## Claims

1. Terminal module (1), on which a function module (7) can be mounted by way of an interface (11), for the modular construction of a control system, with the terminal module having contacts (12) on both sides for control signals, which are connected internally to each other for electrical purposes and also having electrical connections to the interface (11) for the function module, as well as terminal connectors (14), and contacts (13) for a function module (2, 3, 4, 5, 6) and the terminal module being suited to being connected to an adjacent terminal module
**characterised in that**
the terminal connectors (14) and the contacts (13) for the function module are designed differently and have different functions, with the function module to be connected being provided to provide a functionality of the terminal module.

2. Control system with a modular structure comprising at least two terminal modules (1) and two function modules (7), each terminal module has an interface (11), by way of which a corresponding function module can be mounted, each terminal module has contacts (12) on both sides for control signals, which are connected internally to each other for electrical purposes and also have electrical connections to the interface for the function module, and each terminal module has contacts (13) for a function module,
**characterised in that**
the control system has at least one function module (2, 3, 4, 5, 6) which is provided to connect adjacent terminal modules which are connected in a chain by mounting onto the corresponding contacts (13), with the function module to be connected being provided to provide a functionality of the terminal module.

3. Control system according to claim 2,
with an interface module (8) comprising an interface terminal connector being arranged at the start of a chain of at least two terminal modules (1).

4. Control system according to claim 3,
with a termination module (10) being arranged at the end of the chain of at least two terminal modules (1).

5. Control system according to one of claims 2 to 4,
with the function module (2, 3, 4, 5, 6) having means for visualising the provided functionality.

6. Control system according to one of claims 2 to 5, with a maximum width of the width of a terminal module (1) being provided for the function module (2, 3, 4, 5, 6).

7. Control system according to one of claims 2 to 6,
with a function module (2, 3, 4, 5, 6) being embodied as a feed-in module (2), which has connectors for the terminal of a supply voltage, which can only be applied to the right contacts by way of an internal electrical connection, as a result of which the left terminal module (1) can be separated from a potential group which can be started at the terminal module (1) positioned on the right.

8. Control system according to one of claims 2 to 7,
with a function module (2, 3, 4, 5, 6) being embodied as a feed-in module (2), which has connectors for the terminal of a supply voltage, which can only be applied to the left contacts by way of an internal electrical connection, as a result of which the terminal module (1) positioned on the right can be separated from a potential group which can be started at the terminal module (1) positioned on the left.

9. Control system according to one of claims 2 to 8,
with a function module (2, 3, 4, 5, 6) being embodied as a feed-in module (2), which has connectors for the terminal of a supply voltage, which can be applied to the left and right contacts by way of an internal electrical connection.

10. Control system according to one of claims 2 to 9,
with a function module (2, 3, 4, 5, 6) having an additional connector for a PE terminal.

11. Control system according to claim 10,
with a minimum cross-section of 2.5 mm^2 being provided for the PE terminal.

12. Control system according to one of claims 2 to 11,
with a function module (2, 3, 4, 5, 6,) being embodied as a bridge unit (3), which has an internal electrical connection between all or only certain of the left and right contacts.

13. Control system according to one of the preceding claims, with a function module (2, 3, 4, 5, 6) being embodied as a separator unit (4), which has no internal electrical connection between the left and right contacts.

14. Control system according to one of the preceding claims, with a function module being designed as a specialist unit (5), which can contain temperature sensors for instance.

15. Control system according to one of claims 3 to 14, with a termination module (6) being provided at the start and end of the chain in order to cover the free contacts.

16. Control system according to claim 15,
with the termination module (6) having a width of essentially half the width of a terminal module (1).

## Revendications

1. Module ( 1 ) terminal sur lequel un module ( 7 ) fonctionnel peut être enfiché par l'intermédiaire d'une interface ( 11 ) pour la constitution modulaire d'un système de commande, le module terminal ayant des deux côtés des contacts ( 12 ) pour des signaux de commande qui à la fois sont reliés entre eux électriquement de façon interne et ont également des liaisons électriques avec l'interface ( 11 ) pour le module fonctionnel, ainsi que des bornes ( 14 ) de connexion, ainsi que des contacts ( 13 ) pour un bloc ( 2, 3, 4, 5, 6 ) fonctionnel et le module terminal est propre à être relié à un module terminal voisin,
**caractérisé en ce que**
les bornes ( 14 ) de connexion et les contacts ( 13 ) sont conçus différemment pour le module fonctionnel et ont des fonctions différentes, le module fonctionnel à raccorder étant prévu pour disposer d'une fonctionnalité du module terminal.

2. Système de commande modulaire comprenant au moins deux modules ( 1 ) terminaux et deux modules ( 7 ) fonctionnels, chaque module terminal ayant une interface ( 11 ) par laquelle le module fonctionnel correspondant peut être enfiché, chaque module terminal ayant des deux côtés des contacts ( 12 ) pour des signaux de commande qui à la fois sont reliés entre eux électriquement de façon interne et ont aussi des liaisons électriques avec l'interface pour le module fonctionnel, et chaque module terminal a des contacts ( 13 ) pour un bloc fonctionnel,
**caractérisé en ce que**
le système de commande a au moins un bloc ( 2, 3, 4, 5, 6 ) fonctionnel qui est prévu, par enfichage sur les contacts ( 13 ) correspondants, pour la liaison de modules terminaux voisins montés suivant une chaîne, le bloc fonctionnel se raccordant étant prévu pour la mise à disposition d'une fonctionnalité des modules terminaux.

3. Système de commande suivant la revendication 2,
dans lequel un module ( 8 ) d'interface ayant un connecteur de connexion d'interface est disposé au début d'une chaîne d'au moins deux modules ( 1 ) terminaux.

4. Système de commande suivant la revendication 3,
dans lequel un module ( 10 ) de fin est disposé à la fin de la chaîne d'au moins deux modules ( 1 ) terminaux.

5. Système de commande suivant l'une des revendications 2 à 4,
dans lequel le bloc ( 2, 3, 4, 5, 6 ) fonctionnel a des moyens de visualisation de la fonctionnalité mis à disposition.

6. Système de commande suivant l'une des revendications 2 à 5,
dans lequel il est prévu pour le bloc ( 2, 3, 4, 5, 6 ) fonctionnel une largeur maximum de la largeur d'un module ( 1 ) terminal.

7. Système de commande suivant l'une des revendications 2 à 6,
dans lequel un bloc ( 2, 3, 4, 5, 6 ) fonctionnel est réalisé sous la forme d'un bloc ( 2 ) d'alimentation, qui a des bornes pour l'application d'une tension de l'alimentation qui peut être appliquée par une liaison électrique interne seulement au contact de droite, de sorte que le module ( 1 ) terminal à gauche peut être séparé d'un groupe de potentiels pouvant commencer sur le module ( 1 ) terminal de droite.

8. Système de commande suivant l'une des revendications 2 à 7,
dans lequel un bloc ( 2, 3, 4, 5, 6 ) fonctionnel est réalisé sous la forme d'un bloc ( 2 ) d'alimentation, qui a des bornes pour l'application d'une tension d'alimentation qui peut être appliquée par une liaison électrique interne seulement au contact de gauche de sorte que le module ( 1 ) terminal de droite peut être séparé d'un groupe de potentiels pouvant commencer sur le module ( 1 ) terminal de gauche.

9. Système de commande suivant l'une des revendications 2 à 8,
dans lequel un bloc ( 2, 3, 4, 5, 6 ) fonctionnel est réalisé sous la forme d'un bloc ( 2 ) d'alimentation qui a des bornes pour l'application d'une tension d'alimentation, qui peut être appliquée au contact de gauche et de droite par une liaison électrique interne.

10. Système de commande suivant l'une des revendications 2 à 9,
dans lequel un bloc ( 2, 3, 4, 5, 6 ) fonctionnel a une borne supplémentaire pour une connexion PE.

11. Système de commande suivant la revendication 10,
dans lequel il est prévu une section transversale minimum de 2,5 mm² pour la connexion PE.

12. Système de commande suivant l'une des revendications 2 à 11,
dans lequel un bloc ( 2, 3, 4, 5, 6 ) fonctionnel est réalisé en bloc ( 3 ) de pont, qui a une liaison électrique interne entre tous les contacts de gauche ou de droite ou entre seulement certains d'entre eux.

13. Système de commande suivant l'une des revendications précédentes,
dans lequel un bloc ( 2, 3, 4, 5, 6 ) fonctionnel est réalisé en bloc ( 4 ) de séparation, qui n'a pas de liaison électrique entre les contacts de gauche et de droite.

14. Système de commande suivant l'une des revendications précédentes,
dans lequel un bloc fonctionnel est réalisé sous la forme d'un bloc ( 5 ) spécial qui peut comporter par exemple des capteurs de température.

15. Système de commande suivant l'une des revendications 3 à 14,
dans lequel il est prévu au début et à la fin de la scène un bloc ( 6 ) de fin pour recouvrir les contacts libres.

16. Système de commande suivant la revendication 15,
dans lequel le bloc ( 6 ) de fin a une largeur de sensiblement la moitié de la largeur d'un module ( 1 ) terminal.
